# EUROPEAN PATENT APPLICATION

(11) **EP 2 892 080 A1**
(43) Date of publication of application: **08.07.2015**
(21) Application number: 13834100.3
(22) Date of filing: 08.08.2013
(51) Int. Cl.: H01L 31/042, C08L 23/06, C08L 23/08

(54) **PAIR OF SEALING FILMS FOR SOLAR CELL AND METHOD FOR MANUFACTURING SOLAR CELL MODULE USING SAME**

(30) Priority: 31.08.2012 JP 2012191000; 23.05.2013 JP 2013108869
(71) Applicant: Bridgestone Corporation, Tokyo 104-8340 (JP)
(72) Inventor: INAMIYA Takato, Yokohama-shi Kanagawa 244-8510 (JP); KATAOKA Hisataka, Yokohama-shi Kanagawa 244-8510 (JP); ARAAKE Satoshi, Yokohama-shi Kanagawa 244-8510 (JP); KAGA Norihiko, Kodaira-shi Tokyo 187-8531 (JP); TARUTANI Yasunori, Kodaira-shi Tokyo 187-8531 (JP)
(74) Representative: Oxley, Robin John George
(86) International application number: PCT/JP2013/071554
(87) International publication number: WO 2014/034406

(57) **Abstract**

To provide a sealing film for a solar cell, which can be effectively formed and is capable of preventing wraparound even if heating is performed in a wide temperature range when members of the solar cell module are integrated.

A pair of sealing films 13A and 13B for a solar cell including a light-receiving side sealing film 13A formed from a resin composition A; and a colored backside sealing film 13B formed from a resin composition B, wherein a temperature at which the resin composition B has a viscosity of 50,000 Pa·s is 95°C or lower, and the resin composition B has a viscosity higher than that of the resin composition A at 80°C and 100°C.

## Description

### Technical Field

The present invention relates to a pair of sealing films for a solar cell and a method for producing a solar cell module using the same, particularly to a pair of sealing films for a solar cell, capable of preventing wraparound of a colored backside sealing film and a method for producing a solar cell module using the same.

### Background Art

In recent years, solar cell modules, which directly convert sunlight into an electric energy, are widely used, and further development thereof has been advanced in terms of effective utilization of resources and prevention of environmental pollution.

The solar cell module typically has a structure in which photovoltaic elements are sealed by a light-receiving side sealing film and a backside sealing film, which are disposed between a light-receiving side transparent protective member and a backside protective member(a back cover). Conventional solar cell modules have a structure in which a plurality of photovoltaic elements are connected to each other in order to obtain a high electric output. In order to secure insulation properties between the photovoltaic elements, accordingly, sealing films having insulation properties are used.

As the sealing films used for the light-receiving side and the backside, films of an ethylene-polar monomer copolymer such as ethylene-vinyl acetate copolymer (EVA) are preferably used.

In order to improve film strength and durability, a crosslinking density is improved by using a crosslinking agent such as an organic peroxide in the sealing film.

It is strongly desired for the solar cell module to take light entering into the photovoltaic elements in the solar cell module as effective as possible, for improvement of a power generation efficiency. The light-receiving side sealing film is desired to permeate most of the sunlight entering without absorption or reflection of the sunlight. For this reason, a sealing film excellent in transparency is used as the light receiving side sealing film (for example, Patent Literature 1).

On the other hand, as the backside sealing film, ethylene-polar monomer copolymer films colored with a coloring agent such as titanium dioxide (TiO₂) are used (for example, Patent Literature 2). According to such a colored backside sealing film, the light entering into between the photovoltaic elements can be taken into the photovoltaic elements by diffused reflection, utilizing light reflection at an interface between the light-receiving side sealing film and the colored backside sealing film, and diffused reflection of the light by the coloring agent itself inside the solar cell module. This can improve an efficiency of utilization of the light entering into the solar cell module and a power generation efficiency of the solar cell module.

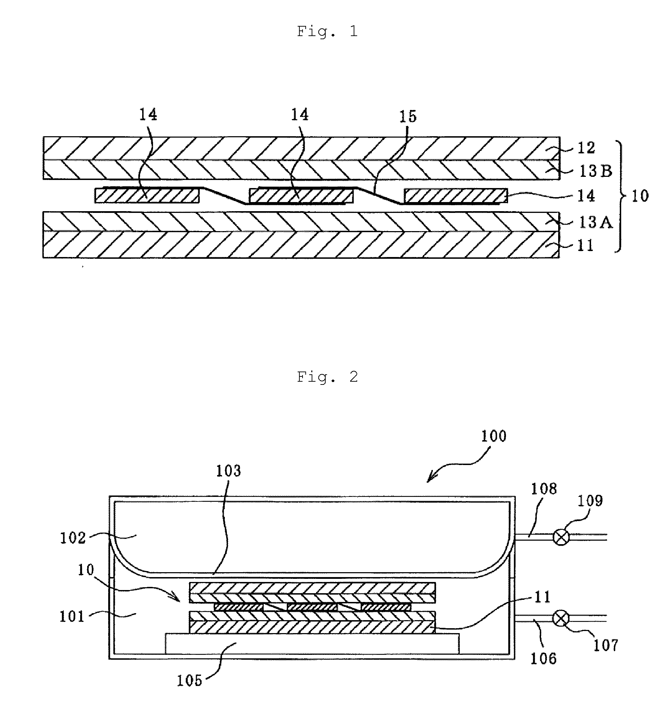

In order to produce a solar cell module, as shown in Fig. 1, a method is used in which a light-receiving side transparent protective member 11, a light-receiving side sealing film 13A, a plurality of photovoltaic elements 14, which are electrically connected to each other through connection tabs 15, a backside sealing film 13B, and a backside protective member 12 (a back cover) are stacked in this order, and the obtained stack 10 is pressurized and heated to crosslink and cure the light-receiving side sealing film and the backside sealing film, thereby integrating the members.

The members in the stack 10 are typically integrated by using a vacuum laminator. As the vacuum laminator, for example, as shown in Fig. 2, a vacuum laminator 100 with double vacuum rooms is used which includes an upper chamber 102 having a diaphragm 103 and a lower chamber 101 in which a mounting stand 105 is provided. The integration is performed by mounting the stack 10 on the mounting stand 105 so that the light-receiving side transparent protective member 11 is located on the bottom side, then putting the upper chamber 102 and the lower chamber 101 into a vacuum state, and setting the pressure in the upper chamber 102 to a pressure of not less than the atmospheric pressure and pressurizing the upper surface of the stack 10 with the diaphragm 103, while the laminate 10 is heated by a heater (not shown in a drawing) built in the mounting stand 105.

### Citation List

### Patent Literature

Patent Literature 1: JP 2008-053379 A
Patent Literature 2: JP 6-177412 A
Patent Literature 3: JP 4467222 B

### Summary of Invention

### Technical Problem

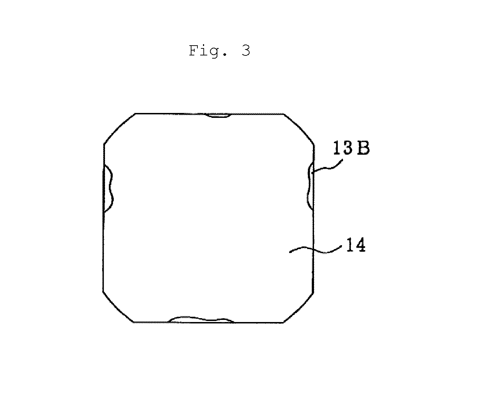

When the laminate is pressurized, however, as shown in a plan view of the light-receiving surface of a photovoltaic element 14 of Fig. 3, the colored backside sealing film 13B, which has melted by heating, may sometimes infiltrate on the light-receiving side of the photovoltaic element 14 (hereinafter, this phenomenon is referred to as "wraparound"). When the wraparound occurs, not only the appearance of the solar cell module is reduced but also the sunlight entering into the photovoltaic elements is reduced to cause a problem of reduction of the power generation efficiency.

For this problem, according to Patent Literature 3, as EVA used for the colored backside sealing film, EVA having a vinyl acetate content lower than that of EVA used for the light-receiving side sealing film is used, whereby the wraparound is prevented. However, EVA having a low vinyl acetate content has a high melting point, as a result, disadvantageously, the film cannot be effectively formed in a stage in which the sealing film is produced.

On the other hand, as a matter of convenience of properties and limitations in each member used in the solar cell module, additives contained in the member, laminator devices, and the like, it is required to perform the heating in a comparative wide temperature range in the integration.

Accordingly, an object of the present invention is to provide a sealing film for a solar cell, capable of effectively performing film formation and preventing wraparound even if the heating is performed in a wide temperature range when each member in a solar cell module.

In addition, an object of the present invention is to provide a method for producing a solar cell module in a high productivity by using the sealing films for a solar cell.

### Solution to Problem

The above object is achieved by a pair of sealing films for a solar cell, comprising a light-receiving side sealing film formed from a resin composition A; and a colored backside sealing film formed from a resin composition B, wherein a temperature at which the resin composition B has a viscosity of 50,000 Pa·s is 95°C or lower, and the resin composition B has a viscosity higher than that of the resin composition A at 80°C and 100°C.

According to the invention, the light-receiving side sealing film, which has a lower viscosity, melts faster than the colored backside sealing film does when the heating is performed in the integration, and it closely adheres to the surface of the photovoltaic element without forming a gap between them, thus the infiltration of the colored backside sealing film on the light receiving surface of the photovoltaic element can be inhibited, whereby the wraparound can be prevented. Also, when there is a difference in the viscosity at each temperature, a viscosity of the resin composition B for the colored backside sealing film is higher than that of the resin composition A for the light-receiving side sealing film in a wide temperature range including a range of 80°C to 100°C, and thus the effect of preventing the wraparound can be obtained, even if the heating is performed in a wide temperature range in the integration. Furthermore, a temperature at which the resin composition B for the colored backside sealing film has a viscosity of 50,000 Pa·s, which is suitable for film formation, is 95°C or lower, and thus the sealing film can be produced in a low cost and a high efficiency in a film-forming apparatus using water temperature control generally used because of the inexpensive capital investment and high accuracy of temperature control.

Preferable aspects of the pair of the sealing films for a solar cell according to the present invention are as follows:
(1) The resin composition A contains an ethylene-polar monomer copolymer, and the resin composition B contains an ethylene-polar monomer copolymer and polyethylene.
   The resin composition A contains the ethylene-polar monomer copolymer while the resin composition B contains polyethylene in addition to the ethylene-polar monomer, and thus the resin composition B can secure a viscosity relatively higher than that of the resin composition A in a wide temperature range.
(2) The resin mixture B has a viscosity of 10,000 to 100,000 Pa·s at 80°C, and a viscosity of 10,000 to 50,000 Pa·s at 100°C.
(3) A difference in the viscosity between the resin composition B and the resin composition A is 10,000 Pa·s or more at 80°C, and the difference in the viscosity is 3,000 Pa·s or more at 100°C.
(4) A mass ratio of the ethylene-polar monomer copolymer (EPM) to the polyethylene (PE) (EPM : PE) in the resin composition B is from 8 : 2 to 3 : 7.
(5) The ethylene-polar monomer copolymer is an ethylene-vinyl acetate copolymer or an ethylene-methyl methacrylate copolymer.

In addition, the above object is also achieved by a method for producing a solar cell module comprising the steps of: stacking a light-receiving side transparent protective member, a light-receiving side sealing film, a photovoltaic element, a colored backside sealing film, and a backside protective member in this order to obtain a stack; and pressurizing and heating the stack to integrate it, wherein as the light-receiving side sealing film and the colored backside sealing film, the above pair of sealing films for a solar cell is used.

Preferable aspects of the method for producing a solar cell module of the present invention are as follows:
(1) The pressurizing is started at a time when temperatures of the light-receiving side sealing film and the colored backside sealing film reach 80 to 100°C by the heating.

### Advantageous Effects of Invention

According to the present invention, the wraparound of the colored backside sealing film on the light receiving side of the photovoltaic element can be prevented when the members of the solar cell module are integrated to each other. In addition, both of the light-receiving side sealing film and the colored backside sealing film can be effectively formed in a film-forming apparatus using water temperature control. As a result, a solar cell module having good appearance and a high power generation efficiency can be obtained in a high productivity.

### Brief Description of Drawings

Fig. 1 is a schematic cross-sectional view of a solar cell module.
Fig. 2 is a schematic cross-sectional view showing a typical vacuum laminator.
Fig. 3 is a plan view of the light-receiving side of a photovoltaic element, showing a state of wraparound.

### Description of Embodiments

As described above, the pair of the sealing films for a solar cell according to the present invention is a pair of two films of a light-receiving side sealing film formed from a resin composition A and a colored backside sealing film formed from a resin composition B. A temperature at which the resin composition B has a viscosity of 50,000 Pa·s is 95°C or lower, and the resin composition B has a viscosity, at 80°C and 100°C, higher than a viscosity of the resin composition A for the light-receiving side sealing film.

The resin mixture B for the colored backside sealing film has a viscosity at 80°C of preferably 10,000 to 100,000 Pa·s, more preferably 30,000 to 98,000 Pa·s, particularly preferably 50,000 to 95,000 Pa·s, and a viscosity at 100°C of preferably 10,000 to 50,000 Pa·s, more preferably 10,000 to 40,000 Pa·s, particularly preferably 15,000 to 30,000 Pa·s. When the viscosity is within the range described above, the wraparound can be effectively prevented, and the integration can be sufficiently performed without occurrence of failed adhesion. In addition, a temperature at which the viscosity of the resin mixture B is 50,000 Pa·s is preferably 95°C or lower, particularly preferably 93°C or lower, and the lower limit thereof is generally 60°C, particularly 70°C. In this situation, the sealing film can be produced in a low cost and a high efficiency in a film-forming apparatus using water temperature control which is generally used because of the inexpensive capital investment and high accuracy of temperature control. The viscosity of 50,000 Pa·s is a viscosity at which the film-formation can be performed in a high efficiency and a film having a high quality can be obtained.

Furthermore, in the pair of the sealing films for a solar cell according to the present invention, the difference in the viscosity at 80°C between the resin composition B and the resin composition A is preferably 10,000 Pa·s or more, more preferably 20,000 Pa·s or more, and the difference in the viscosity at 100°C is preferably 3,000 Pa·s or more, more preferably 5,000 Pa·s or more. When the difference in the viscosity is sufficient, the wraparound can be more advantageously prevented.

The resin composition A has a viscosity of, for example, 6,000 to 50,000 Pa·s at 80°C, preferably 7,000 to 30,000 Pa·s, and has a viscosity of 3,000 to 15,000 Pa·s at 100°C, preferably 4,000 to 12,000 Pa·s.

The viscosity can be determined by measuring a viscosity every 1°C using Capillograph ID (furnace body diameter: φ 9.55 mm, capillary: φ 1.0 × 10 mm, manufactured by Toyo Seiki Co., Ltd.) at a test speed of 1 mm/minutes.

In the present invention, it is preferred that the resin composition A for the light-receiving side sealing film comprises an ethylene-polar monomer copolymer as a base polymer and the resin composition B for the colored backside sealing film comprises a resin mixture of an ethylene-polar monomer copolymer and polyethylene as a base polymer.

The resin composition A comprises the ethylene-polar monomer copolymer, while the resin composition B comprises polyethylene in addition to the ethylene-polar monomer, and thus the resin composition B can secure a viscosity relatively higher than that of the resin composition A in a wide temperature range.

The polar monomer of the ethylene-polar monomer copolymer (which may also be referred to as "EPM") may be exemplified by unsaturated carboxylic acids, salts, esters and amides thereof, vinyl esters, carbon monooxide, and the like. More specifically, they may include one or more kinds of unsaturated carboxylic acids such as acrylic acid, methacrylic acid, fumaric acid, itaconic acid, monomethyl maleate, monoethyl maleate, maleic anhydride and itaconic anhydride, salts of the unsaturated carboxylic acid with a monovalent metal such as lithium, sodium or potassium, or salts thereof with a polyvalent metal such as magnesium, calcium or zinc; unsaturated carboxylic acid esters such as methyl acrylate, ethyl acrylate, isopropyl acrylate, isobutyl acrylate, n-butyl acrylate, isooctyl acrylate, methyl methacrylate, ethyl methacrylate, isobutyl methacrylate and dimethyl maleate; vinyl esters such as vinyl acetate and vinyl propionate; carbon monooxide, sulfur dioxide, and the like.

Typical examples of the ethylene-polar monomer copolymer may include, more specifically, ethylene-unsaturated carboxylic acid copolymers such as an ethylene-acrylic acid copolymer and an ethylene-methacrylic acid copolymer, and ionomers in which a part or all of carboxyl groups of the ethylene-unsaturated carboxylic acid copolymer are neutralized with the metal described above; ethylene-unsaturated carboxylic acid ester copolymers such as an ethylene-methyl acrylate copolymer, an ethylene-ethyl acrylate copolymer, an ethylene-methyl methacrylate copolymer, an ethylene-isobutyl acrylate copolymer and an ethylene-n-butyl acrylate copolymer; ethylene-unsaturated carboxylic acid ester-unsaturated carboxylic acid copolymers such as an ethylene-isobutyl acrylate-methacrylic acid copolymer, and an ethylene-n-butyl acrylate-methacrylic acid copolymer and ionomers in which a part or all of the carboxyl groups in the copolymer described above are neutralized with the metal described above; ethylene-vinyl ester copolymers such as an ethylene-vinyl acetate copolymer, and the like. They may be used alone or as a mixture of two or more kinds.

In the present invention, it is preferable to use ethylene-vinyl acetate copolymer (EVA) or ethylene-methyl methacrylate copolymer (EMMA) as the ethylene-polar monomer copolymer in both of the resin compositions A and B. These copolymers are not only excellent in transparency, which is required for the sealing film but also has an appropriate flexibility, and thus it is possible to form a sealing film for a solar cell capable of certainly preventing the wraparound when applying the pressure in the preparation of the solar cell module.

A mass ratio of the ethylene-polar monomer copolymer (EPM) to the polyethylene (PE) (EPM : PE) in the resin composition B for the colored backside sealing film is preferably from 8 : 2 to 3 : 7, more preferably from 6 : 4 to 3 : 7. When the mass ratio is within the range described above, the composition B can secure a viscosity higher than that of the resin composition A in a wider temperature range, and the adhesiveness sufficient as the sealing film can be obtained.

When EVA is used as the ethylene-polar monomer copolymer, a vinyl acetate content in the EVA contained in the resin composition B for the colored backside sealing film is preferably from 20 to 35% by mass, more preferably from 20 to 32% by mass. On the other hand, a vinyl acetate content of EVA contained in the resin composition A for the light-receiving side sealing film is preferably from 20 to 35% by mass, particularly preferably from 24 to 32% by mass. When the contents are within the ranges described above, the resin compositions having a viscosity suitable for the present invention can be obtained.

When EMMA is used as the ethylene-polar monomer copolymer, in both cases where it is used for the colored backside sealing film and for the light-receiving side sealing film, a methyl methacrylate content of EMMA is from 15 to 35% by mass, preferably 18 to 27% by mass, particularly preferably from 20 to 25% by mass.

As the ethylene-polar monomer copolymer which can be used in the light-receiving side sealing film and the colored backside sealing film, it is preferable to use a copolymer having a melt flow rate, defined by JIS K 7210, of 35 g/10 min or less, particularly preferably 3 to 30 g/10 min. When using such a copolymer, the wraparound can be advantageously prevented and good sealing property can be obtained. In the present invention, a value of the melt flow rate (MFR) is measured at 190°C in a condition of a load of 21.18 N in accordance with JIS K 7210.

When the resin composition B for the colored backside sealing film comprises polyethylene, the polyethylene is a polymer mainly comprising ethylene, and includes homopolymer of ethylene, a copolymer of ethylene and 5 mol% or less of an α-olefin having 3 or less carbon atoms (for example, butene-1, hexene-1, 4-methylpentene-1, octene-1, and the like), and a copolymer of ethylene and 1 mol% or less of a non-olefin monomer having only carbon, oxygen or hydrogen atom as a functional group, as defined in JIS (JIS K 6922-1:1997). PE is generally classified according to the density, and may include a high density polyethylene (HDPE), a low density polyethylene (LDPE), a linear low density polyethylene (LLDPE), and the like.

LDPE is typically a polyethylene obtained by polymerization of ethylene at a high pressure of 100 to 350 MPa in the presence of a radical generating agent such as an organic peroxide, which has long chain branching and has a density (in accordance with JIS K 7112, hereinafter the same) of, typically, 0.910 g/cm³ or more and less than 0.930 g/cm³. LLDPE is typically obtained by copolymerization of ethylene and an α-olefin in the presence of a transition metal catalyst such as a Ziegler catalyst, a Philips catalyst or a metallocene catalyst, which has a density of typically 0.910 to 0.940 g/cm³, preferably 0.910 to 0.930 g/cm³. HDPE is a polyethylene having a density of, typically, 0.942 to 0.970 g/cm³. The polyethylene used in the present invention is preferably the low density polyethylene or the linear low density polyethylene in terms of the processability.

Examples of the combination of the resins used in the resin composition A and the resin composition B may include a combination of EVA for the resin composition A and a mixture of EVA and PE for the resin composition B; a combination of EVA for the resin composition A and a mixture of EMMA and PE for the resin composition B; a combination of EMMA for the resin composition A and a mixture of EVA and PE for the resin composition B; and a combination of EMMA for the resin composition A and a mixture of EMMA and PE for the resin composition B.

In each of the resin composition A and the resin composition B, in addition to the polymers described above, a polyvinyl acetal resin (for example, polyvinyl formal, polyvinyl butyral (PVB resin), modified PVB), or a vinyl chloride resin may be secondarily used. In such a case, PVB is particularly preferred.

In the present invention, the resin composition A and the resin composition B preferably comprise a crosslinking agent which forms a crosslinked structure of a base polymer which is contained in each composition. It is preferable to use an organic peroxide or a photo-polymerization initiator as the crosslinking agent. Of these, it is preferable to use the organic peroxide, because a sealing film having excellent adhesion and humidity resistance can be obtained.

Any organic peroxide can be used so long as it decomposes at a temperature of 100°C or higher to generate radicals. The organic peroxide is selected typically considering a film-forming temperature, control conditions of the composition, a curing temperature, and heat resistance and storage stability of an adherend. Organic peroxides having a half-life of 10 hours and a decomposition temperature of 70°C or higher are particularly preferred.

Examples of the organic peroxide may include, from the viewpoint of the processing temperature and storage stability of the resin, benzoyl peroxide curing agents, tert-hexyl peroxypivalate, tert-butyl peroxypivalate, 3,5,5-trimethyl hexanoyl peroxide, di-n-octanoyl peroxide, lauroyl peroxide, stearoyl peroxide, 1,1,3,3-tetramethyl butyl peroxy-2-ethyl hexanoate, succinic acid peroxide, 2,5-dimethyl-2,5-di(tert-butylperoxy)hexane, 2,5-dimethyl-2,5-di(2-ethylhexanoylperoxy)hexane, 1-cyclohexyl-1-methylethylperoxy-2-ethyl hexanoate, tert-hexyl peroxy-2-ethyl hexanoate, 4-methylbenzoyl peroxide, tert-butylperoxy-2-ethyl hexanoate, m-toluoyl+benzoyl peroxide, benzoyl peroxide, 1,1-bis(tert-butylperoxy)-2-methyl cyclohexanate, 1,1-bis(tert-hexylperoxy)-3,3,5-trimethyl cyclohexanate, 1,1-bis(tert-hexylperoxy)cyclohexanate, 1,1-bis(tert-butylperoxy)-3,3,5-trimethyl cyclohexane, 1,1-bis(tert-butylperoxy)cyclohexane, 2,2-bis(4,4-di-tert-butyl peroxycyclohexyl)propane, 1,1-bis(tert-butylperoxy)cyclododecane, tert-hexyl peroxyisopropyl monocarbonate, tert-butyl peroxymaleic acid, tert-butyl peroxy-3,3,5-trimethyl hexane, tert-butyl peroxylaurate, 2,5-dimethyl-2,5-di(methylbenzoylperoxy)hexane, tert-butyl peroxyisopropyl monocarbonate, tert-butyl peroxy-2-ethylhexyl monocarbonate, tert-hexyl peroxybenzoate, 2,5-di-methyl-2,5-di(benzoylperoxy)hexane, and the like.

Any benzoyl peroxide curing agent can be used so long as it decomposes at a temperature of 70°C or higher to generate radicals, and benzoyl peroxides having a half-life of 10 hours and a decomposition temperature of 50°C or higher are preferable. The organic peroxide can appropriately selected considering preparation conditions, a film-forming temperature, a curing (bonding) temperature, and heat resistance and storage stability of an adherend. Examples of the benzoyl peroxide curing agent, which can be used, may include benzoyl peroxide, 2,5-dimethylhexyl-2,5-bisperoxybenzoate, p-chlorobenzoyl peroxide, m-toluoyl peroxide, 2,4-dichlorobenzoyl peroxide, t-butyl peroxybenzoate, and the like. The benzoyl peroxide curing agents may be alone or as a mixture of two or more kinds.

It is particularly preferable to use 2,5-dimethyl-2,5-di(t-butylperoxy)hexane as the organic peroxide. The content of the organic peroxide is preferably from 0.1 to 5 parts by mass, more preferably from 0.2 to 3 parts by mass, based on 100 parts by mass of the base polymer in both of the resin compositions A and B.

As the photo-polymerization initiator, any known photo-polymerization initiator can be used, and it is desirable to use an initiator having good storage stability after blending it. It is possible to use, as such a photo-polymerization initiator, for example, acetophenone initiators such as 2-hydroxy-2-methyl-1-phenylpropan-1-one, 1-hydroxycyclohexyl phenyl ketone, and 2-methyl-1-(4-(methylthio)phenyl)-2-morpholinopropane-1; benzoin initiators such as benzyl dimethyl ketal; benzophenone initiators such as benzophenone, 4-phenyl benzophenone and hydroxybenzophenone; thioxanthone initiators such as isopropyl thioxanthone and 2-4-diethyl thioxanthone; other special initiators such as methyl phenyl glyoxylate. Particularly preferable examples may include 2-hydroxy-2-methyl-1-phenylpropan-1-one, 1-hydroxycyclohexyl phenyl ketone, 2-methyl-1-(4-(methylthio)phenyl)-2-morpholinopropane-1, benzophenone, and the like. The photo-polymerization initiators may be used as a mixture thereof with one or more kinds of known and commonly used photo-polymerization accelerators such as a benzoic acid accelerator including 4-dimethylaminobenzoic acid and a tertiary amine accelerator in an arbitrary ratio, if necessary. The photo-polymerization initiators may be used alone or as a mixture of two or more kinds.

The content of the photo-polymerization initiator is preferably from 0.1 to 5 parts by mass, more preferably from 0.2 to 3 parts by mass, based on 100 parts by mass of the base polymer in both of the resin compositions A and B.

The resin composition A and the resin composition B may further include, if necessary, a crosslinking auxiliary agent. The crosslinking auxiliary agent can improve a gel rate of resins included in each resin composition, and improve the adhesiveness and the durability of the sealing film.

The content of the crosslinking auxiliary agent is typically 10 parts by mass or less, preferably from 0.1 to 5 parts by mass, more preferably from 0.1 to 2.5 parts by mass, based on 100 parts by mass of the base polymer in both of the resin compositions A and B. In such a case, the sealing film having the excellent adhesiveness can be obtained.

Examples of the crosslinking auxiliary agent (a compound having a radical-polymerizable group as a functional group) may include monofunctional or difunctional crosslinking auxiliary agents such as (meth)acrylic esters (for example, NK esters, and the like), and the like, in addition to trifunctional crosslinking auxiliary agents such as triallyl cyanurate and triallyl isocyanurate. Of these, triallyl cyanurate and triallyl isocyanurate are preferable, and triallyl isocyanurate is particularly preferred.

The resin composition A and the resin composition B have preferably the excellent adhesiveness, considering the sealing property inside the solar cell module. To that end, they may further include an adhesiveness improver. Silane coupling agents may be used as the adhesive improver. It is possible to form the sealing film for a solar cell, which has the excellent adhesiveness, by using it. Examples of the silane coupling agent may include γ-chloropropylmethoxysilane, vinyltriethoxysilane, vinyltris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane, N-β-(aminoethyl)- γ-aminopropyltrimethoxysilane, and the like. The silane coupling agents may be used alone or as a mixture of two or more kinds. Of these, γ-methacryloxypropyltrimethoxysilane is particularly preferred.

It is preferred that the content of the silane coupling agent is 5 parts by mass or less, preferably from 0.1 to 2 parts by mass, based on 100 parts by mass of the base polymer in both of the resin compositions A and B.

The resin composition B for the colored backside sealing film includes a coloring agent. The coloring agent is appropriately selected so as to obtain a desired color tone. It is possible to use, for example, white coloring agents such as titanium white (titanium dioxide) or calcium carbonate; blue coloring agents such as ultramarine; black coloring agents such as carbon black; milky-white coloring agents such as glass beads or a light diffusion agent, and the like. The white coloring agent of the titanium white can be preferably used.

The content of the coloring agent is typically from 0.1 to 10 parts by mass, more preferably from 0.5 to 6 parts by mass, based on 100 parts by mass of the base polymer in the resin composition B for the colored backside sealing film.

The light-receiving side sealing film and the colored backside sealing film may include, if necessary, a plasticizer, various additives such as an acryloxy group-containing compound, a methacryloxy group-containing compound and/or an epoxy group-containing compound, a ultraviolet absorber, light stabilizer, or an antioxidant, in order to improve or control various film physical properties (the mechanical strength, optical properties, heat-resistance, light resistance, crosslinking speed, and the like).

The light-receiving side sealing film and the colored backside sealing film may be formed according to a known method. For example, the compositions comprising the components described above are subjected to a usual extrusion molding or calendaring to form it into a sheet, whereby the sealing films can be produced. In the pair of sealing the films for a solar cell according to the present invention, the temperature at which the resin composition B for the colored backside sealing film has a viscosity 50,000 Pa·s is 95°C or lower, and the resin composition A for the light-receiving side sealing film has a viscosity lower than that of the resin composition B; as a result, it is possible to produce both of the light-receiving side sealing film and the colored backside sealing film in the film-forming apparatus using the water temperature control, the film-formation can be performed in a low cost and a high efficiency. Although the film-forming temperature varies depending on the viscosity of each resin composition, it is typically 95°C or lower, preferably from 70 to 90°C. The thickness of the light-receiving side sealing film or the colored backside sealing film is not particularly limited, and it is, for example, from 0.5 to 2 mm.

Other members used in the method for producing a solar cell module of the present invention will be explained in detailed below.

As a light-receiving side transparent protective member used in the solar cell module, glass substrates such as silicate glass can be usually used. The light-receiving side transparent protective member has a thickness of typically 0.1 to 10 mm, preferably 0.3 to 5 mm. In general, the light-receiving side transparent protective member may be chemically or thermally reinforced.

As a backside protective member used in the solar cell module, plastic films such as polyethylene terephthalate (PET) or polyamide are preferably used. Considering the heat-resistance and the moisture-resistance, fluorinated polyethylene films, in particular, a film of fluorinated polyethylene film/Al/fluorinated polyethylene film, which film is obtained by laminating them in this order, a film of polyvinyl fluoride (Trademark: Tedlar)/PET/polyvinyl fluoride, which film is obtained by laminating them in this order, may be used.

A photovoltaic element used in the solar cell module, is an element capable of performing photovoltaic conversion, and a conventionally known semiconductor substrate is used. As the semiconductor substrate, a photo semiconductor element formed of monocrystals, polycrystals, or an amorphous substance is used. Specifically, amorphous silicon a-Si, hydrogenated amorphous silicon a-Si:H, hydrogenated amorphous silicon carbide a-SiC:H, and amorphous silicon nitride are used, and semiconductor layers are also used which are obtained by forming an amorphous substance or fine crystals of amorphous silicon semiconductor formed of an alloy of silicon with another element such as carbon, germanium or tin into a pin-type, nip-type, ni-type, pn-type, MIS-type, heterojunction, homojunction, Schottky barrier, or mixed type thereof. In addition, the optical semiconductor may be CdS, GaAs, InP, or the like.

The photovoltaic element may be incorporated into the solar cell module in accordance with a conventionally known method.

For example, an inner lead such as a copper foil formed by solder plating is connected to an electrode of the photovoltaic element, and the photovoltaic elements are connected in serial-parallel through the inner lead so that a pre-determined electric output can be taken out from the solar cell module.

Next, the method for producing a solar cell module of the present invention will be explained. The method for producing a solar cell module of the present invention includes, as shown in Fig. 1, the steps of: stacking a light-receiving side transparent protective member 11, a light-receiving side sealing film 13A, photovoltaic elements 14, a colored backside sealing film 13B, and a backside protective member 12 in this order to obtain a stack 10; and pressurizing and heating the stack 10 to integrate it. The step in which the stack 10 is pressurized and heated is preferably performed using, for example, a vacuum laminator having an expandable diaphragm, in particular a vacuum laminator 100 with double vacuum chambers shown in Fig. 2.

The vacuum laminator 100 shown in Fig. 2 has an upper chamber 102 in which a diaphragm 103 is provided and a lower chamber 101 in which a mounting stand 105 is provided for mounting the stack 10. In the vacuum laminator 100, insides of the upper chamber 102 and the lower chamber 101 are subjected to vacuum pumping, and then the stack 10 is pressurized with the diaphragm 103. The vacuum pumping of the insides of the upper chamber 102 and the lower chamber 101 is performed by using a vacuum pump 107 for the lower chamber connected to an exhaust vent 106 for the lower chamber and a vacuum pump 109 for the upper chamber connected to an exhaust vent 108 for the upper chamber.

For pressurizing the stack 10 using such a vacuum laminator, first, the stack 10 in which the light-receiving side transparent protective member 11, the light-receiving side sealing film 13A, the photovoltaic elements 14, the colored backside sealing film 13B, and the backside protective member 12 are stacked in this order is mounted on the mounting stand 105 provided in the lower chamber 101. Then, the insides of the upper chamber 102 and the lower chamber 101 are reduced to vacuum by using the vacuum pump 109 for the upper chamber and the vacuum pump 107 for the lower chamber, respectively, and then the inside pressure of the upper chamber 102 is set to a pressure, preferably, equal to or more than the atmospheric pressure. By this operation, the uppermost surface of the stack 10 was pressed by the diaphragm 103 to pressurize the stack 10.

In order to evaluate the insides of the upper chamber 102 and the lower chamber 101, it is preferable that, first, the inner pressures of the upper chamber 102 and the lower chamber 101 are each reduced to 50 to 150 Pa, particularly to 50 to 100 Pa. The vacuum pressure is, for example, kept for 0.1 to 5 minutes. After that, the pressure inside the upper chamber is adjusted to 40 to 110 kPa, particularly 60 to 105 kPa, whereby the stack is uniformly pressurized with the diaphragm 103.

It is preferable that a dilatation of the diaphragm is controlled so that the stack is pressurized with a pressure of 1.0 × 10³ Pa to 5.0 × 10⁷ Pa, particularly 60 to 105 kPa. The press time is, for example, from 5 to 15 minutes.

According to the method of the present invention, heating is performed at the same time of the pressurization. The heating method may include a method in which the whole of the vacuum laminator 100 shown in Fig. 2 is put in a high temperature environment, such as an oven, to heat it;
a method in which a heating medium such as a heating plate is introduced into the inside of the lower chamber 101 in the vacuum laminator 100 shown in Fig. 2 to heat the stack 10, and the like. The latter method is performed, for example, by using a heating plate as the mounting stand 105, disposing a heating plate on the upper side and/or the lower side of the mounting stand 105, or disposing a heating plate on the upper side and/or the lower side of the stack.

Of these heating methods, it is preferable to perform the heating from the side of the light-receiving side transparent protective member 11, for example, using the heating plate as the mounting stand 105. When such a heating is performed, heat is conducted faster to the light-receiving side sealing film 13A than heat is conducted to the colored backside sealing film 13B, and accordingly the light-receiving side sealing film 13A melts relatively faster than the colored backside sealing film 13B does and it closely adheres to the light receiving surface of the photovoltaic element 14, whereby the wraparound can be more certainly prevented.

It is preferable that the stack 10 is heated to a temperature of 130 to 170°C, preferably 140 to 160°C. The pressurization using the diaphragm described above is typically started in the course of temperature rising by heating.

For example, in a case where the stack is heated to 140 to 160°C, the pressurization is started at the time when the temperatures of the pair of sealing the films 13A and 13B for a solar cell both reach 80 to 100°C in the course of the heating. Then, the temperature is increased after the starting of the pressurization to 140 to 160°C, and the stack is retained for a given time as it is.

According to the present invention, when the stack 10 is heated, the light-receiving side sealing film having a lower viscosity melts faster than the colored backside sealing film does, and it closely adheres to the surface of the photovoltaic element without forming a gap between them, thus the infiltration of the colored backside sealing film on the light-receiving surface of the photovoltaic element can be inhibited, whereby the wraparound can be prevented. Also, when there is the difference in the viscosity between the resin composition A and the resin composition B at 80°C and 100°C, the viscosity of the resin composition B for the colored backside sealing film is higher than that of the resin composition A for the light-receiving side sealing film in a wide temperature range including a range of 80°C to 100°C, and thus the effect of preventing the wraparound can be obtained, even if the heating is performed in a wide temperature range in the integration.

### [Example]

The present invention will be explained in more detailed by means of Examples below.

### 1. Production of colored backside sealing film

The materials of the formulation shown in Tables described below were supplied to a roll mill and kneaded at a chamber temperature of 110°C. The obtained resin composition for the colored backside sealing film was shaped by calendaring at 80°C to produce a colored backside sealing film (a thickness of 0.5 mm).

### 2. Production of light-receiving side sealing films (1) to (6)

### • Light-receiving side sealing film (1)

The materials of the formulation described below was supplied to a roll mill and kneaded at 90°C. The obtained resin composition for the light-receiving side sealing film was shaped by calendaring at 70°C to obtain a light-receiving side sealing film (1) (a thickness of 0.5 mm). The resin composition had a viscosity of 26,000 Pa·s at 80°C, a viscosity of 12,000 Pa·s at 90°C, and a viscosity of 9,800 Pa·s at 100°C.

### (Formulation)

- Ethylene-vinyl acetate copolymer (Vinyl acetate content: 26% by mass, MFR: 4.3 g/10 min, Melting point: 76°C) 100 parts by mass
- Crosslinking agent (2,5-dimethyl-2,5-di(t-butylperoxy)hexane)
   (PERHEXA 25B: manufactured by NOF Corporation) 1.3 parts by mass
- Crosslinking auxiliary agent (triallyl isocyanurate) (TAIC manufactured by Nippon Kasei Chemical Co., Ltd.) 1.5 parts by mass
- Silane coupling agent (γ-methacryloxypropyltrimethoxysilane) (KBM 503 manufactured by Shin-Etsu Chemical Co., Ltd.) 0.3 parts by mass

A light-receiving side sealing film (2) was produced in the same manner as in the production of the light-receiving side sealing film (1) except that UE 750 (a melting point of 66°C, a vinyl acetate content of 32% by mass and an MFR of 30 g/10 min, manufactured by TOSOH Corporation) was used as EVA. The resin composition for forming the light-receiving side sealing film (2) had a viscosity of 7,000 Pa·s at 80°C, a viscosity of 5,500 Pa·s at 90°C, and a viscosity of 4,000 Pa·s at 100°C.

A light-receiving side sealing film (3) was produced in the same manner as in the production of the backside sealing film in Example 2 shown in Table 1, except that the coloring agent was not blended. The resin composition for forming the light-receiving side sealing film (3) had a viscosity of 57,000 Pa·s at 80°C, a viscosity of 30,000 Pa·s at 90°C, and a viscosity of 16,000 Pa·s at 100°C.

A light-receiving side sealing film (4) was produced in the same manner as in the production of the light-receiving side sealing film (1) except that EMMA (a melting point of 80°C, an MMA content of 25% by mass, and an MFR 7 g/10 min, Acryft WK 307 manufactured by Sumitomo Chemical Co., Ltd.) was used instead of EVA. The resin composition for forming the light-receiving side sealing film (4) had a viscosity of 26,000 Pa·s at 80°C, a viscosity of 12,000 Pa·s at 90°C, and a viscosity of 9,800 Pa·s at 100°C.

A light-receiving side sealing film (5) was produced in the same manner as in the production of the backside sealing film of Example 11 except that the coloring agent was not blended. The resin composition for forming the light-receiving side sealing film (5) had a viscosity of 57,000 Pa·s at 80°C, a viscosity of 30,000 Pa·s at 90°C, and a viscosity of 16,000 Pa·s at 100°C.

A light-receiving side sealing film (6) was produced in the same manner as in the production of the backside sealing film of Example 17 except that the coloring agent was not blended. The resin composition for forming the light-receiving side sealing film (6) had a viscosity of 82,000 Pa·s at 80°C, a viscosity of 30,000 Pa·s at 90°C, and a viscosity of 15,000 Pa·s at 100°C.

### 3. Production of solar cell module

A light-receiving side transparent protective member (reinforced transparent glass plate (with emboss), 230 mm × 230 mm × 3.2 mm), the light-receiving side sealing film described above, photovoltaic elements (single crystal silicon cell of 125 mm × 125 mm, and a thickness of 220 µm), the colored backside sealing film described above, a backside protective member (PET, a thickness of 350 µm) were stacked in this order, and then the resulting stack was heated and pressurized under the conditions of a vacuum time of 5 minutes, a pressure of 0.1 MPa and a press time of 15 minutes using a vacuum laminator with double vacuum chambers as shown in Fig. 2 to integrate (laminate) it, thereby producing a solar cell module.

The stack was pressurized by mounting the light-receiving side transparent protective member on the mounting stand in the laminator so that the member was located on the bottom side, and pressing it with the diaphragm from the side of the backside protective member. The heating is performed using a heating plate as the mounting stand and increasing the temperature to 140°C, 150°C, or 160°C, as shown in Table below. When the heating temperature was 140°C, 150°C, or 160°C, the pressurization was started at the time when the temperatures of the light-receiving side sealing film and the colored backside sealing film reached 80°C, 90°C, or 100°C, respecrively. The temperature of each sealing film at the start of the pressurization was confirmed by measuring a temperature of the sealing film using a K thermocouple connected to NR 1000, manufactured by Keyence Corporation, which was attached to the sealing film.

### <Evaluation Method>

### 1. Laminate property (Wraparound)

In the produced solar cell module, a wraparound quantity of the colored backside sealing film on the light receiving surface of the photovoltaic element was measured. The measurement of the wraparound quantity was performed by measuring a length (mm) from the edge of the photovoltaic element to a point at which the colored backside sealing film was most infiltrated with a scale. When the wraparound length was 300 µm or less, the laminate was evaluated as ○; and when it was more than 300 µm, the laminate was evaluated as ×. When the failed adhesion occurred, the laminate was evaluated as Δ. In Evaluation, "-" shows that the evaluation of the film formation was so bad that the lamination was not performed.

### 2. Film Formation (Deviation in Thickness)

The evaluation of the film formation was performed by measuring a deviation in the thickness of the colored backside sealing film when the calendar-shaping was performed. Specifically, the film was cut in the width direction into strips having a width of 50 mm, and the measurement was performed using an off-line thickness measuring apparatus TOF-4F (manufactured by Yamabun Electronics Co., Ltd). A case of a range within 450 to 550 µm to a 500 µm target was evaluated as ○, and a case of out of the range of 450 to 550 µm was evaluated as ×. The sealing films having a deviation in the thickness within a range of 450 to 550 µm were films which could be obtained by good film formation without occurrence of waviness.

The results are shown in Tables below. In the Examples, the viscosity was measured every 1°C using Capillograph ID (furnace body diameter: φ 9.55 mm, capillary: φ 1.0 × 10 mm, manufactured by Toyo Seiki Co., Ltd.) at a test speed of 1 mm/minute.

**[Table 1]**

| | | | Example 1 | Example 2 | Example 3 | Example 4 | Example 5 | Example 6 | Example 7 |
|---|---|---|---|---|---|---|---|---|---|
| Light-receiving side sealing film | | | (1) | (1) | (1) | (1) | (2) | (1) | (1) |
| Backside sealing film Formulation (parts by mass) | EVA (1) UE750 | | - | - | - | - | 60 | - | - |
| | EVA (2) UE634 | | 60 | 60 | 60 | - | - | 50 | 30 |
| | EVA (3) UE633 | | - | - | - | 60 | - | - | - |
| | EVA (4) V206 | | - | - | - | - | - | - | - |
| | EVA (5) V210 | | - | - | - | - | - | - | - |
| | EVA (6) V215 | | - | - | - | - | - | - | - |
| | EVA (7) V319 | | - | - | - | - | - | - | - |
| | PE (1) 228-1 | | 40 | - | - | - | - | - | - |
| | PE (2) 202 | | - | 40 | - | 40 | - | 50 | 70 |
| | PE (3) Z322 | | - | - | - | - | - | - | - |
| | PE (4) UF230 | | - | - | - | - | - | - | - |
| | PE (5) UJ790 | | - | - | 40 | - | 40 | - | - |
| | Coloring agent | | 4 | 4 | 4 | 4 | 4 | 4 | 4 |
| | Crosslinking agent | | 1.3 | 1.3 | 1.3 | 1.3 | 1.3 | 1.3 | 1.3 |
| | Crosslinking auxiliary agent | | 1.5 | 1.5 | 1.5 | 1.5 | 1.5 | 1.5 | 1.5 |
| | Adhesiveness improver | | 0.3 | 0.3 | 0.3 | 0.3 | 0.3 | 0.3 | 0.3 |
| Propertis (Backside sealing film) | Temperature (°C) at a viscosity of 50000 Pa·s | | 85 | 81 | 82 | 82 | 73 | 85 | 93 |
| | Viscosity (Pa·s) at 80°C | | 72,000 | 57,000 | 65,000 | 50,000 | 32,000 | 72,500 | 86,000 |
| | Viscosity (Pa·s) at 90°C | | 42,000 | 30,000 | 36,000 | 30,000 | 22,000 | 41,000 | 63,000 |
| | Viscosity (Pa·s) at 100°C | | 29,000 | 16,000 | 25,000 | 20,000 | 15,000 | 22,200 | 26,000 |
| Evaluation | Deviation in thickness | | ○ | ○ | ○ | ○ | ○ | ○ | ○ |
| | Laminate property | 140°C | ○ | ○ | ○ | ○ | ○ | ○ | ○ |
| | | 150°C | ○ | ○ | ○ | ○ | ○ | ○ | ○ |
| | | 160°C | ○ | ○ | ○ | ○ | ○ | ○ | ○ |
| Total evaluation | | | ○ | ○ | ○ | ○ | ○ | ○ | ○ |

**[Table 2]**

| | | | Example 8 | Example 9 | Com. Ex. 1 | Com. Ex. 2 | Com. Ex. 3 | Com. Ex. 4 | Com. Ex. 5 | Com. Ex. 6 |
|---|---|---|---|---|---|---|---|---|---|---|
| Light-receiving side sealing film | | | (1) | (1) | (1) | (1) | (1) | (1) | (1) | (1) |
| Backside wealing film Formulation(parts by mass) | EVA (1) UE750 | | - | - | - | - | - | - | - | - |
| | EVA (2) UE634 | | 80 | 60 | 60 | 100 | - | - | - | - |
| | EVA (3) UE633 | | - | - | - | - | - | - | - | - |
| | EVA (4) V206 | | - | - | - | - | 100 | - | - | - |
| | EVA (5) V210 | | - | - | - | - | - | 100 | - | - |
| | EVA (6) V215 | | - | - | - | - | - | - | 100 | - |
| | EVA (7) V319 | | - | - | - | - | - | - | - | 100 |
| | PE (1) 228-1 | | 20 | - | - | - | - | - | - | - |
| | PE (2) 202 | | - | - | - | - | - | - | - | - |
| | PE (3) Z322 | | - | - | - | - | - | - | - | - |
| | PE (4) UF230 | | - | - | 40 | - | - | - | - | - |
| | PE (5) UJ790 | | - | - | - | - | - | - | - | - |
| | PE (6) 249 | | - | 40 | - | - | - | - | - | - |
| | Coloring agent | | 4 | 4 | 4 | 4 | 4 | 4 | 4 | 4 |
| | Crosslinking agent | | 1.3 | 1.3 | 1.3 | 1.3 | 1.3 | 1.3 | 1.3 | 1.3 |
| | Crosslinking auxiliary agent | | 1.5 | 1.5 | 1.5 | 1.5 | 1.5 | 1.5 | 1.5 | 1.5 |
| | Adhesiveness improver | | 0.3 | 0.3 | 0.3 | 0.3 | 0.3 | 0.3 | 0.3 | 0.3 |
| Properties (Backside sealing film) | Temperature (°C) at a viscosity of 50,000 Pa·s | | 79 | 80 | 102 | 75 | 104 | 96 | 85 | 84 |
| | Viscosity (Pa·s) at 80°C | | 56,000 | 55,000 | 110,000 | 26,000 | 500,000 | 450,000 | 110,000 | 75,000 |
| | Viscosity (Pa·s) at 90°C | | 31,000 | 28,000 | 74,000 | 12,000 | 370,000 | 130,000 | 19,000 | 16,000 |
| | Viscosity (Pa·s) at 100°C | | 23,000 | 13,000 | 52,000 | 9,800 | 110,000 | 16,000 | 5,100 | 5,300 |
| Evaluation | Deviation in thickness | | ○ | ○ | × | ○ | × | × | ○ | ○ |
| | Laminate property | 140°C | ○ | ○ | - | ○ | - | - | Δ | ○ |
| | | 150°C | ○ | ○ | - | ○ | - | - | ○ | ○ |
| | | 160°C | ○ | ○ | - | × | - | - | × | × |
| Total evaluation | | | ○ | ○ | × | × | × | × | × | × |

**[Table 3]**

| | | | Com. Ex. 7 | Com. Ex. 8 | Com. Ex. 9 | Com. Ex. 10 | Com. Ex. 11 |
|---|---|---|---|---|---|---|---|
| Light-receiving side sealing film | | | (1) | (1) | (3) | (1) | (1) |
| Backside sealing film Formulation (parts by mass) | EVA (1) UE750 | | 60 | - | - | - | - |
| | EVA (2) UE634 | | - | 60 | 100 | 80 | 20 |
| | EVA (3) UE633 | | - | - | - | - | - |
| | EVA (4) V206 | | - | - | - | - | - |
| | EVA (5) V210 | | - | - | - | - | - |
| | EVA (6) V215 | | - | - | - | - | - |
| | EVA (7) V319 | | - | - | - | - | - |
| | PE (1) 228-1 | | - | - | - | - | - |
| | PE (2) 202 | | 40 | - | - | 20 | 80 |
| | PE (3) Z322 | | - | 40 | - | - | - |
| | PE (4) UF230 | | - | - | - | - | - |
| | PE (5) UJ790 | | - | - | - | - | - |
| | Coloring agent | | 4 | 4 | 4 | 4 | 4 |
| | Crosslinking agent | | 1.3 | 1.3 | 1.3 | 1.3 | 1.3 |
| | Crosslinking auxiliary agent | | 1.5 | 1.5 | 1.5 | 1.5 | 1.5 |
| | Adhesiveness improver | | 0.3 | 0.3 | 0.3 | 0.3 | 0.3 |
| Properties (Backside sealing film) | Temperature (°C) at a viscosity of 50,000 Pa·s | | 76 | 104 | 75 | 75 | 98 |
| | Viscosity (Pa·s) at 80°C | | 23,000 | 150,000 | 26,000 | 41,500 | 105,000 |
| | Viscosity (Pa·s) at 90°C | | 16,000 | 80,000 | 12,000 | 19,000 | 80,000 |
| | Viscosity (Pa·s) at 100°C | | 8,800 | 55,000 | 9,800 | 9,800 | 35,000 |
| Evaluation | Deviation in thickness | | ○ | × | ○ | ○ | × |
| | Laminate property | 140°C | ○ | - | × | ○ | ○ |
| | | 150°C | ○ | - | × | ○ | ○ |
| | | 160°C | × | - | × | × | × |
| Total evaluation | | | × | × | × | × | × |

**[Table 4]**

| | | | Example 10 | Example 11 | Example 12 | Example 13 | Example 14 | Example 15 |
|---|---|---|---|---|---|---|---|---|
| Light-receiving side sealing film | | | (4) | (4) | (4) | (4) | (4) | (4) |
| Backside sealing film Formulation (parts by mass) | EMMA (1) WK402 | | - | - | - | - | - | - |
| | EMMA (2) WK307 | | - | - | - | - | - | - |
| | EMMA (3) WK401 | | - | - | - | - | - | - |
| | EVA (2) UE634 | | 60 | 60 | 60 | - | 50 | 30 |
| | EVA (3) UE633 | | - | - | - | 60 | - | - |
| | EVA (4) V206 | | - | - | - | - | - | - |
| | EVA (5) V210 | | - | - | - | - | - | - |
| | EVA (6) V215 | | - | - | - | - | - | - |
| | EVA (7) V319 | | - | - | - | - | - | - |
| | PE (1) 228-1 | | 40 | - | - | - | - | - |
| | PE (2) 202 | | - | 40 | - | 40 | 50 | 70 |
| | PE (3) Z322 | | - | - | - | - | - | - |
| | PE (4) UF230 | | - | - | - | - | - | - |
| | PE (5) UJ790 | | - | - | 40 | - | - | - |
| | Coloring agent | | 4 | 4 | 4 | 4 | 4 | 4 |
| | Crosslinking agent | | 1.3 | 1.3 | 1.3 | 1.3 | 1.3 | 1.3 |
| | Crosslinking auxiliary agent | | 1.5 | 1.5 | 1.5 | 1.5 | 1.5 | 1.5 |
| | Adhesiveness improver | | 0.3 | 0.3 | 0.3 | 0.3 | 0.3 | 0.3 |
| Properties (Backside sealing film) | Temperature (°C) at a viscosity of 50,000 Pa·s | | 85 | 81 | 82 | 82 | 85 | 93 |
| | Viscosity (Pa·s) at 80°C | | 72,000 | 57,000 | 65,000 | 50,000 | 72,500 | 86,000 |
| | Viscosity (Pa·s) at 90°C | | 42,000 | 30,000 | 36,000 | 30,000 | 41,000 | 63,000 |
| | Viscosity (Pa·s) at 100°C | | 29,000 | 16,000 | 25,000 | 20,000 | 22,200 | 26,000 |
| Evaluation | Deviation in thickness | | ○ | ○ | ○ | ○ | ○ | ○ |
| | Laminate property | 140°C | ○ | ○ | ○ | ○ | ○ | ○ |
| | | 150°C | ○ | ○ | ○ | ○ | ○ | ○ |
| | | 160°C | ○ | ○ | ○ | ○ | ○ | ○ |
| Total evaluation | | | ○ | ○ | ○ | ○ | ○ | ○ |

**[Table 5]**

| | | | Com. Ex. 12 | Com. Ex. 13 | Com. Ex. 14 | Com. Ex. 15 | Com. Ex. 16 | Com. Ex. 17 | Com. Ex. 18 | Com. Ex. 19 | Com. Ex. 20 |
|---|---|---|---|---|---|---|---|---|---|---|---|
| Light-receiving side sealing film | | | (4) | (4) | (4) | (4) | (4) | (4) | (4) | (4) | (5) |
| Backside sealing film Formulation(parts by mass) | EMMA (1) WK402 | | - | - | - | - | - | - | - | - | - |
| | EMMA (2) WK307 | | - | - | - | - | - | - | - | - | 100 |
| | EMMA (3) WK401 | | - | - | - | - | - | - | - | - | - |
| | EVA (2) UE634 | | 100 | - | - | - | 60 | 60 | 90 | 20 | - |
| | EVA (3) UE633 | | - | - | - | - | - | - | - | - | - |
| | EVA (4) V206 | | - | 100 | - | - | - | - | - | - | - |
| | EVA (5) V210 | | - | - | 100 | - | - | - | - | - | - |
| | EVA (6) V215 | | - | - | - | 100 | - | - | - | - | - |
| | EVA (7) V319 | | - | - | - | - | - | - | - | - | - |
| | PE (1) 228-1 | | - | - | - | - | - | - | - | - | - |
| | PE (2) 202 | | - | - | - | - | - | - | 10 | 80 | - |
| | PE (3) Z322 | | - | - | - | - | 40 | - | - | - | - |
| | PE (4) UF230 | | - | - | - | - | - | 40 | - | - | - |
| | PE (5) UJ790 | | - | - | - | - | - | - | - | - | - |
| | Coloring agent | | 4 | 4 | 4 | 4 | 4 | 4 | 4 | 4 | 4 |
| | Crosslinking agent | | 1.3 | 1.3 | 1.3 | 1.3 | 1.3 | 1.3 | 1.3 | 1.3 | 1.3 |
| | Crosslinking auxiliary agent | | 1.5 | 1.5 | 1.5 | 1.5 | 1.5 | 1.5 | 1.5 | 1.5 | 1.5 |
| | Adhesiveness improver | | 0.3 | 0.3 | 0.3 | 0.3 | 0.3 | 0.3 | 0.3 | 0.3 | 0.3 |
| Properties (Backside sealing film) | Temperature (°C) at a viscosity of 50,000 Pa·s | | 75 | 104 | 96 | 85 | 104 | 102 | 90 | 98 | 75 |
| | Viscosity (Pa·s) at 80°C | | 26,000 | 500,000 | 500,000 | 100,000 | 200,000 | 100,000 | 25,000 | 100,000 | 26,000 |
| | Viscosity (Pa·s) at 90°C | | 12,000 | 400,000 | 100,000 | 19,000 | 80,000 | 74,000 | 11,000 | 80,000 | 12,000 |
| | Viscosity (Pa·s) at 100°C | | 9,800 | 100,000 | 16,000 | 5,100 | 55,000 | 52,000 | 9,200 | 35,000 | 9,800 |
| Evaluation | Deviation in thickness | | ○ | × | × | ○ | × | × | ○ | × | ○ |
| | Laminate property | 140°C | ○ | - | - | Δ | - | - | ○ | - | × |
| | | 150°C | ○ | - | - | ○ | - | - | ○ | - | × |
| | | 160°C | × | - | - | × | - | - | × | - | × |
| Total evaluation | | | × | × | × | × | × | × | × | × | × |

**[Table 6]**

| | | | Example 16 | Example 17 | Example 18 | Example 19 | Example 20 |
|---|---|---|---|---|---|---|---|
| Light-receiving side sealing film | | | (4) | (4) | (4) | (4) | (4) |
| Backside sealing film Formulation (parts by mass) | EMMA (1) WK402 | | - | - | - | - | - |
| | EMMA (2) WK307 | | 60 | 60 | - | 50 | 30 |
| | EMMA (3) WK401 | | - | - | 60 | - | - |
| | PE (1) 228-1 | | 40 | - | - | - | - |
| | PE (2) 202 | | - | 40 | 40 | 50 | 70 |
| | PE (3) Z322 | | - | - | - | - | - |
| | PE (4) UF230 | | - | - | - | - | - |
| | PE (5) UJ790 | | - | - | - | - | - |
| | Coloring agent | | 4 | 4 | 4 | 4 | 4 |
| | Crosslinking agent | | 1.3 | 1.3 | 1.3 | 1.3 | 1.3 |
| | Crosslinking auxiliary agent | | 1.5 | 1.5 | 1.5 | 1.5 | 1.5 |
| | Adhesiveness improver | | 0.3 | 0.3 | 0.3 | 0.3 | 0.3 |
| Properties (Backside sealing film) | Temperature (°C) at a viscosity of 50,000 Pa·s | | 90 | 82 | 89 | 84 | 87 |
| | Viscosity (Pa·s) at 80°C | | 95,000 | 82,000 | 95,000 | 85,000 | 95,000 |
| | Viscosity (Pa·s) at 90°C | | 50,000 | 30,000 | 45,000 | 40,000 | 35,000 |
| | Viscosity (Pa·s) at 100°C | | 25,000 | 15,000 | 15,000 | 15,000 | 18,000 |
| Evaluation | Deviation in thickness | | ○ | ○ | ○ | ○ | ○ |
| | Laminate property | 140°C | ○ | ○ | ○ | ○ | ○ |
| | | 150°C | ○ | ○ | ○ | ○ | ○ |
| | | 160°C | ○ | ○ | ○ | ○ | ○ |
| Total evaluation | | | ○ | ○ | ○ | ○ | ○ |

**[Table 7]**

| | | | Com. Ex. 21 | Com. Ex. 22 | Com. Ex. 23 | Com. Ex. 24 | Com. Ex. 25 | Com. Ex. 26 | Com. Ex. 27 |
|---|---|---|---|---|---|---|---|---|---|
| Light-receiving side sealing film | | | (4) | (4) | (4) | (4) | (4) | (4) | (6) |
| Backside sealing film Formulation (parts by mass) | EMMA (1) WK402 | | 100 | - | - | - | - | - | - |
| | EMMA (2) WK307 | | - | 100 | - | 60 | 60 | 80 | 100 |
| | EMMA (3) WK401 | | - | - | 100 | - | - | - | - |
| | PE (1) 228-1 | | - | - | - | - | - | - | - |
| | PE (2) 202 | | - | - | - | - | - | 20 | - |
| | PE (3) Z322 | | - | - | - | - | - | - | - |
| | PE (4) UF230 | | - | - | - | 40 | - | - | - |
| | PE (5) UJ790 | | - | - | - | - | 40 | - | - |
| | Coloring agent | | 4 | 4 | 4 | 4 | 4 | 4 | 4 |
| | Crosslinking agent | | 1.3 | 1.3 | 1.3 | 1.3 | 1.3 | 1.3 | 1.3 |
| | Crosslinking auxiliary agent | | 1.5 | 1.5 | 1.5 | 1.5 | 1.5 | 1.5 | 1.5 |
| | Adhesiveness improver | | 0.3 | 0.3 | 0.3 | 0.3 | 0.3 | 0.3 | 0.3 |
| Properties (Backside sealing film) | Temperature (°C) at a viscosity of 50,000 Pa·s | | 79 | 80 | 86 | 105 | 103 | 78 | 75 |
| | Viscosity (Pa·s) at 80°C | | 26,000 | 79,000 | 86,000 | 300,000 | 250,000 | 40,000 | 26,000 |
| | Viscosity (Pa·s) at 90°C | | 7,000 | 16,000 | 15,000 | 105,000 | 180,000 | 15,000 | 12,000 |
| | Viscosity (Pa·s) at 100°C | | 5,100 | 9,500 | 4,800 | 70,000 | 70,000 | 6,000 | 9,800 |
| Evaluation | Deviation in thickness | | ○ | ○ | ○ | × | × | ○ | ○ |
| | Laminate property | 140°C | ○ | ○ | ○ | - | - | ○ | × |
| | | 150°C | × | ○ | ○ | - | - | ○ | × |
| | | 160°C | × | × | × | - | - | × | × |
| Total evaluation | | | × | × | × | × | × | × | × |

Details of each material are as follows:
EVA (1): A melting point of 66°C, a vinyl acetate content of 32% by mass, and an MFR of 30 g/10 min
   (Ultrathene UE 750 manufactured by TOSOH Corporation)
EVA (2): A melting point 76°C, a vinyl acetate content of 26% by mass, and an MFR of 4.3 g/10 min
   (Ultrathene UE 634 manufactured by TOSOH Corporation)
EVA (3): A melting point of 83°C, a vinyl acetate content of 20% by mass, and an MFR of 20 g/10 min
   (Ultrathene UE 633 manufactured by TOSOH Corporation)
EVA (4): A melting point of 102°C, a vinyl acetate content of 6% by mass, and an MFR of 2 g/10 min
   (V 206 manufactured by Ube-Maruzen Polyethylene Co., Ltd.)
EVA (5): A melting point of 95°C, a vinyl acetate content of 10% by mass, and an MFR of 4 g/10 min
   (V 210 manufactured by Ube-Maruzen Polyethylene Co., Ltd.)
EVA (6): A melting point of 89°C, a vinyl acetate content of 15% by mass, and an MFR of 2 g/10 min
   (V 215 manufactured by Ube-Maruzen Polyethylene Co., Ltd.)
EVA (7): A melting point of 85°C, and a vinyl acetate content of 19% by mass, and an MFR of 15 g/10 min
   (V 319 manufactured by Ube-Maruzen Polyethylene Co., Ltd.)
PE (1): A melting point of 111°C, an MFR of 1.5 g/10 min,
   LDPE, a density of 0.924 g/cm³
   (Petrothene 228-1 manufactured by TOSOH Corporation)
PE (2): A melting point of 106°C, an MFR of 24 g/10 min, LDPE, a density of 0.918 g/cm³
   (Petrothene 202 manufactured by TOSOH Corporation)
PE (3): A melting point of 119°C, an MFR of 1 g/10 min, LDPE, a density of 0.933 g/cm³
   (Z 322 manufactured by Ube-Maruzen Polyethylene Co., Ltd.)
PE (4): A melting point of 121°C, an MFR 1 g/10 min, LLDPE, a density of 0.921 g/cm³
   (UF 230 manufactured by Japan Polyethylene Corporation)
PE (5): A melting point of 124°C, an MFR of 50 g/10 min, LLDPE, a density of 0.928 g/cm³
   (UJ 790 manufactured by Japan Polyethylene Corporation)
PE (6): A melting point of 102°C, an MFR of 70 g/10 min, LDPE, a density of 0.916 g/cm³
   (Petrothene 249 manufactured by TOSOH Corporation)
EMMA (1): A melting point of 79°C, an MMA content of 25% by mass, and an MFR of 20 g/10 min
   (Acryft WK 402 manufactured by Sumitomo Chemical Co., Ltd.)
EMMA (2): A melting point of 80°C, an MMA content of 25% by mass, and an MFR of 7 g/10 minutes
   (Acryft WK 307 manufactured by Sumitomo Chemical Co., Ltd.)
EMMA (3): A melting point of 86°C, an MMA content of 20% by mass, and an MFR of 20 g/10 min
   (Acryft WK 401 manufactured by Sumitomo Chemical Co., Ltd.) Coloring Agent: Titanium dioxide fine particles, an average particle size of 0.3 µm
   (manufactured by Ishihara Sangyo Kaisha Ltd.)
   Crosslinking Agent: 2,5-dimethyl-2,5-di(t-butylperoxy)hexane
   (Perhexa 25B manufactured by NOF Corporation)
   Crosslinking auxiliary agent: Triallyl isocyanurate
   (TAIC manufactured by Nippon Kasei Chemical Co., Ltd.)
   Adhesiveness Improver: γ-methacryloxypropyltrimethoxysilane
   (KBM 503 manufactured by Shin-Etsu Chemical Co., Ltd.)

### <Evaluation Results>

When the resin composition for the colored backside sealing film had a viscosity higher than that of resin composition for the light-receiving side sealing film at 80°C and 100°C, the wraparound was prevented at every time of heating temperatures of 140°C, 150°C and 160°C, i.e., it was confirmed that the adhesive-integration could be preferably performed in a wide range. In addition, when the temperature at which the resin composition B for the colored backside sealing film had a viscosity of 50,000 Pa·s was 95°C or lower, it was confirmed that the deviation in thickness was good, and the film-formation was performed well without occurrence of waviness.

### Reference Signs List

10: laminate
11: light-receiving side transparent protective member
12: backside protective member
13A: light-receiving side sealing film
13B: colored backside sealing film
14: photovoltaic element
15: connection tab
100: vacuum laminator
101: lower chamber
102: upper chamber
103: diaphragm
105: mounting stand
106: exhaust vent for lower chamber
107: vacuum pump for lower chamber
108: exhaust vent for upper chamber
109: vacuum pump for upper chamber

## Claims

1. A pair of sealing films for a solar cell, comprising:
a light-receiving side sealing film formed from a resin composition A; and
a colored backside sealing film formed from a resin composition B, wherein
a temperature at which the resin composition B has a viscosity of 50,000 Pa·s is 95°C or lower, and the resin composition B has a viscosity higher than that of the resin composition A at 80°C and 100°C.

2. The pair of the sealing films for a solar cell according to claim 1, wherein the resin composition A comprises an ethylene-polar monomer copolymer, and the resin composition B comprises an ethylene-polar monomer copolymer and polyethylene.

3. The pair of the sealing films for a solar cell according to claim 1 or 2, wherein the resin mixture B has a viscosity of 10,000 to 100,000 Pa·s at 80°C, and a viscosity of 10,000 to 50,000 Pa·s at 100°C.

4. The pair of the sealing films for a solar cell according to any one of claims 1 to 3, wherein a difference in the viscosity between the resin composition B and the resin composition A is 10,000Pa·s or more at 80°C, and the difference in the viscosity is 3,000 Pa·s or more at 100°C.

5. The pair of the sealing films for a solar cell according to any one of claims 2 to 4, wherein a mass ratio of the ethylene-polar monomer copolymer (EPM) to the polyethylene (PE) (EPM : PE) in the resin composition B is from 8 : 2 to 3 : 7.

6. The pair of the sealing films for a solar cell according to any one of claims 2 to 5, wherein the ethylene-polar monomer copolymer is an ethylene-vinyl acetate copolymer or an ethylene-methyl methacrylate copolymer.

7. A method for producing a solar cell module comprising the steps of:
stacking a light-receiving side transparent protective member, a light-receiving side sealing film, a photovoltaic element, a colored backside sealing film, and a backside protective member in this order to obtain a stack; and
pressurizing and heating the stack to integrate it,
wherein as the light-receiving side sealing film and the colored backside sealing film, a pair of sealing films for a solar cell according to any one of claims 1 to 6 is used.

8. The method according to claim 7, wherein the pressurizing is started at a time when temperatures of the light-receiving side sealing film and the colored backside sealing film reach 80 to 100°C by the heating.
